# EUROPEAN PATENT SPECIFICATION

(11) **EP 2 384 810 B1**
(45) Date of publication and mention of the grant of the patent: **12.09.2018**
(21) Application number: 09838398.7
(22) Date of filing: 22.12.2009
(51) Int. Cl.: B01J 19/00, B81B 1/00, B81C 3/00

(54) **REACTOR AND METHOD FOR PRODUCING A REACTOR**
REAKTOR UND VERFAHREN ZUR HERSTELLUNG EINES REAKTORS
RÉACTEUR ET PROCÉDÉ DE FABRICATION DE RÉACTEUR

(30) Priority: 13.01.2009 JP 2009004166
(43) Date of publication of application: 09.11.2011
(73) Proprietor: Kabushiki Kaisha Kobe Seiko Sho, Chuo-ku Kobe-shi Hyogo 651-8585 (JP)
(72) Inventor: Yoshida, Tatsuo, Takasago-shi, Hyogo 676-8670 (JP); Noishiki, Koji, Takasago-shi, Hyogo 676-8670 (JP)
(74) Representative: TBK
(86) International application number: PCT/JP2009/071307
(87) International publication number: WO 2010/082433

(56) References cited:
- EP-A2- 1 724 001
- JP-A- 2004 290 971
- JP-A- 2006 122 735
- JP-A- 2006 255 634
- JP-A- 2007 061 685
- JP-A- 2008 168 173
- JP-T- 2006 523 522

## Description

### Technical Field

The present invention relates to a reactor and a method for manufacturing a reactor.

### Background Art

It has been a conventional practice to produce a desired reaction product by reacting a first reactant and a second reactant with each other while permitting the flows of the both reactants held into contact. A reactor **according to the preamble of claim 1 is** disclosed in Patent Document 1 **and** is used in producing these product, for example.

Each example of the reactor disclosed in Patent Document 1 is shown in FIG.10 and FIG. 11.

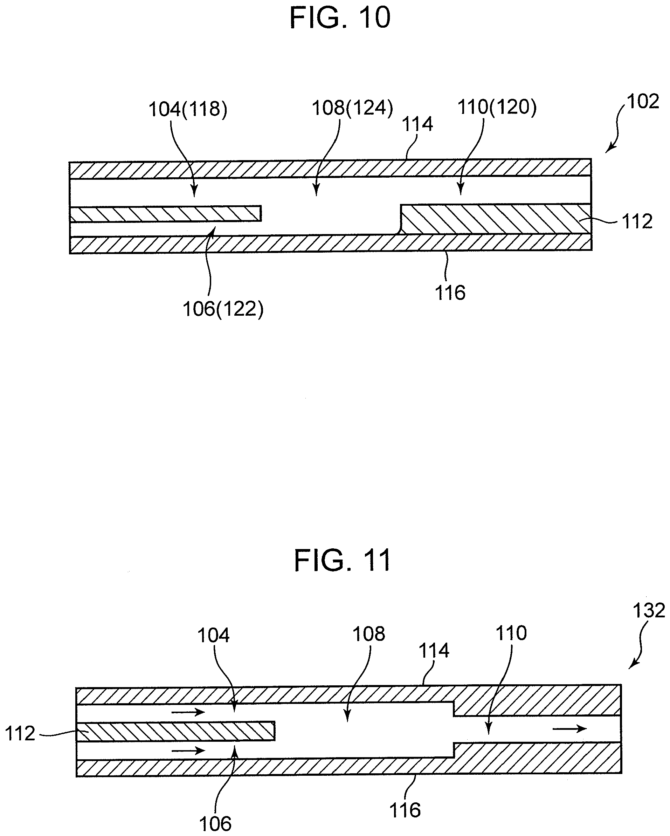

The reactor shown in FIG. 10 includes a channel forming body 102 internally formed with a channel permitting the flows of the reactants. The channel in the channel forming body 102 is comprised of a first inlet path 104 having the first reactant introduced thereinto, a second inlet path 106 having the second reactant introduced thereinto, a junction channel 108 for causing the reactants flowing via the respective inlet paths 104, 106 to join, and a reaction channel 110 for reacting the two reactants joined in the junction channel 108 while permitting the flows thereof.

The channel forming body 102 is made up of a base plate 112 and a pair of sealing plates 114, 116 united with the base plate 112 sandwiched between the sealing plates. A first inlet groove 118 for forming the first inlet path 104 and a reaction groove 120 for forming the reaction channel 110 are formed in one surface of the base plate 112, and a second inlet groove 122 for forming the second inlet path 106 is formed in other surface of the base plate 112. Further, a junction hole 124 for forming the junction channel 108 penetrates the base plate 112 from the one surface to the other surface between a downstream ends of the inlet grooves 118, 122 and an upstream end of the reaction groove 120 to connect the respective grooves 118, 122, 120. The first inlet path 104, the second inlet path 106, the junction channel 108 and the reaction channel 110 are formed by covering respective openings of the grooves 118, 122, 120 and the junction hole 124 by the corresponding sealing plates 114, 116. In this reactor, a bottom surface of the first inlet groove 118 and a bottom surface of the reaction groove 120 are flush with each other.

In the above arrangement, since the bottom surface of the first inlet groove 118 and the bottom surface of the reaction groove 120 are flush with each other, the first reactant smoothly flows straight, on the other hand, since the second inlet groove 122 is formed in a surface of the base plate 112 opposite to the surface formed with the first inlet groove 118 and the reaction groove 120, the second reactant joins to the straight flow of the first reactant halfway. Therefore, it is relatively difficult to sufficiently mix the second reactant with the first reactant, as a result, it is difficult to improve a mixing uniformity of the both reactants.

if the path reaching from the first inlet path 104 to the reaction channel 110 via the junction channel 108 is bent such that the first reactant flows toward the downstream side while moving from the one surface of the base plate 112 toward the other surface of the base plate 112 and the path reaching from the second inlet path 106 to the reaction channel 110 via the junction channel 108 is bent such that the second reactant flows toward the downstream side while moving from the other surface of the base plate 112 toward the one surface of the base plate 112, the both reactants join while moving in the directions toward each other, with the result that the mixing uniformity of the both reactants can be improved.

However, if it is tried to form the channel forming body 132 shown in FIG.11, it is necessary to etch the both sealing plates 114, 116 such that only the parts of the both sealing plates 114, 116 corresponding to the reaction channel 110 project in addition to etch for forming the grooves corresponding to the first inlet path 104, the second inlet path 106, the reaction channel 110 and the junction channel 108 in the base plate 112, thereby the etching steps increase. Further, the both sealing plates 114, 116 need to be bonded to the base plate 112 while being positioned to fit the projecting parts thereof into the part of the etched base plate 112 corresponding to the reaction channel 110, wherefore the process of bonding the sealing plates 114, 116 and the base plate 112 becomes cumbersome. Thus, in this arrangement, there is a problem that the manufacturing process of the reactor becomes cumbersome.

Patent Document 1: Japanese Patent Application Publication JP 2008-168173 A

### Summary of the Invention

It is an object of the present invention to provide a reactor and a method for manufacturing a reactor that can resolve the above-described problems.

It is another object of the present invention to prevent to make the manufacturing process of the reactor cumbersome while improving the mixing uniformity of the reactants in the reactor.

**The above object is achieved with a reactor having the features of claim 1 and a method for manufacturing a reactor having the features of claim 2.**

### Brief Description of the Drawings

FIG. 1 is a perspective view showing a reactor according to one embodiment of the invention.
FIG. 2 is an exploded perspective view of first and second channel forming bodies constituting a channel device of the reactor shown in FIG. 1.
FIG. 3 is a diagram schematically showing a positional relationship of a first inlet path group, a second inlet path group, a junction channel group and a reaction channel group in the first channel forming body.
FIG. 4 is a plan view of one surface of a base plate forming the first channel forming body.
FIG. 5 is a plan view of the other surface of the base plate forming the first channel forming body.
FIG. 6 is a section diagram along a channel of a part of the first channel forming body near a junction channel.
FIG. 7 is a partial section diagram of the first channel forming body along VII-VII of FIG. 6.
FIG. 8 is a partial section diagram of the first channel forming body along VIII-VIII of FIG. 6.
FIG. 9 is a partial section diagram of the first channel forming body along IX-IX of FIG. 6.
FIG. 10 is a section diagram along a channel of a channel forming body of a reactor according to a conventional example.
FIG. 11 is a section diagram along a channel of a channel forming body of a reactor according to another conventional example.

### Mode for Carrying Out the Invention

Hereinafter, embodiments of the present invention are described with reference to the drawings.

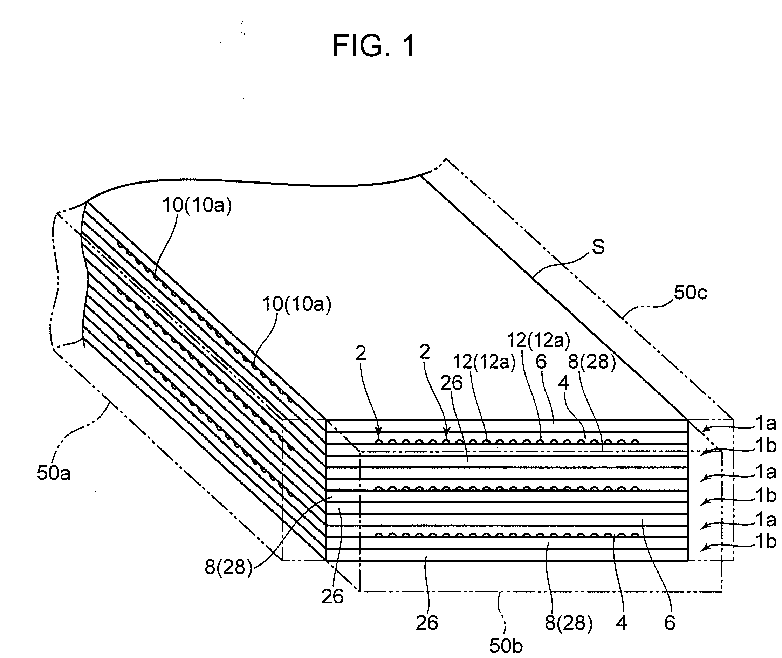

First of all, with reference to FIGS. 1 to 9, the construction of a reactor according to one embodiment of the present invention is described.

The reactor according to this embodiment is provided with a channel device S as shown in FIG. 1. This channel device S is formed by alternately laminating a plurality of first channel forming bodies 1a each internally formed with a plurality of channels 2 for permitting the flows of reactants and a plurality of second channel forming bodies 1b internally formed with a plurality of heating medium channels for permitting the flow of a heating medium. Out of these two channel forming bodies 1a, 1b, the first channel forming bodies 1a are embraced by the concept of the channel forming body of the present invention.

The reactor of this embodiment is generally called a microreactor and produces a desired reaction product by reacting first and second reactants while permitting the flows thereof in a plurality of microchannels 2 formed in the first channel forming bodies 1a.

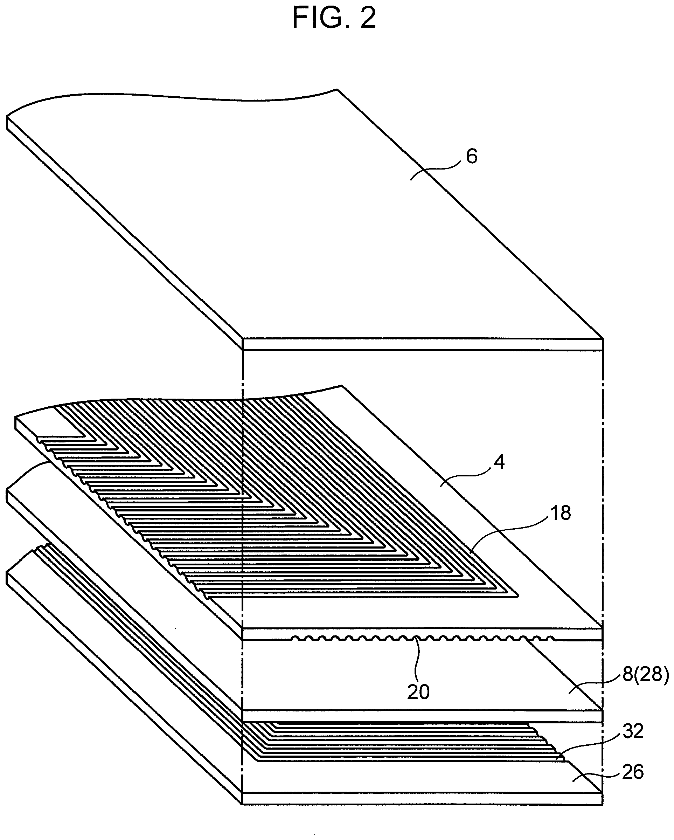

Specifically, the first channel forming body 1a is made up of a base plate 4, a first sealing member 6 and a second sealing member 8. These base plate 4, first sealing member 6 and second sealing member 8 are respectively rectangular flat boards as shown in FIG. 2. The first sealing member 6 is bonded to one surface of the base plate 4 while covering this one surface. The second sealing member 8 is bonded to the other surface of the base plate 4 while covering this other surface. In other words, the sealing members 6, 8 and the base plate 4 are united with the base plate 4 sandwiched between the first and second sealing members 6, 8, thereby forming the first channel forming body 1a.

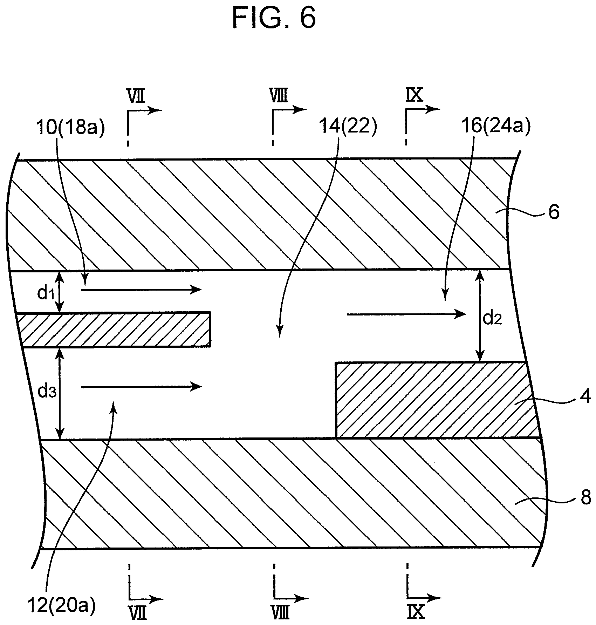

In the first channel forming body 1a, the plurality of channels 2 are formed side by side in a width direction of the first channel forming body 1a along the base plate 4. Each channel 2 is comprised of a first inlet path 10, a second inlet path 12, a junction channel 14 (see FIG. 6) and a reaction channel 16 (see FIG. 6). The first inlet path 10 is a portion into which the first reactant is introduced. The second inlet path 12 is a portion into which the second reactant is introduced. The junction channel 14 is connected with a downstream side of the first inlet path 10 and a downstream side of the second inlet path 12. The junction channel 14 is a portion serving to cause the first reactant flowing via the first inlet path 10 and the second reactant flowing via the second inlet path 12 to join. The reaction channel 16 is connected with a downstream side of the junction channel 14. The reaction channel 16 is a portion serving to react the two reactants joined in the junction channel 14 while permitting the flows thereof.

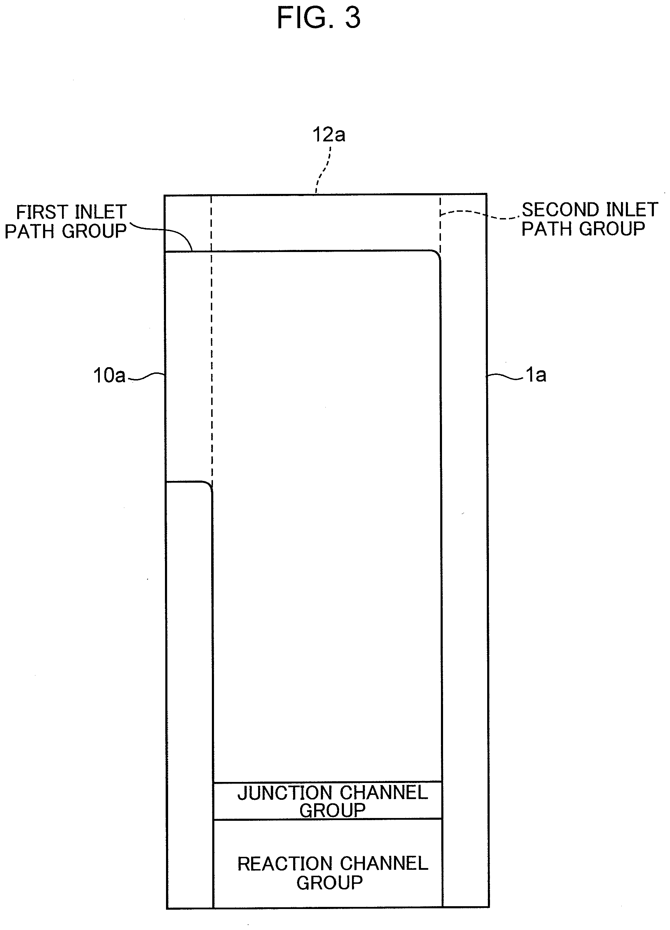

In the first channel forming body 1a, a group made up of the first inlet paths 10 of the respective channels 2, a group made up of the second inlet paths 12 of the respective channels 2, a group made up of the junction channels 14 of the respective channels 2 and a group made up of the reaction channels 16 of the respective channels 2 are arranged in such a positional relationship as shown in FIG. 3.

Each first inlet path 10 has an inlet opening 10a at one widthwise end of the first channel forming body 1a. Each first inlet path 10 extends straight in the width direction of the first channel forming body 1a from the inlet opening 10a, is bent by 90 degrees and extends straight in a longitudinal direction of the first channel forming body 1a. A first reactant supply unit 50a (see FIG. 1) is connected with the inlet openings 10a of the respective first inlet paths 10. The first reactant is introduced to the respective first inlet paths 10 from the first reactant supply unit 50a while being distributed among them.

The respective first inlet paths 10 have different channel lengths. Specifically, the respective first inlet paths 10 are arranged side by side at equal intervals in the width direction of the first channel forming body 1a, and the first inlet paths 10 arranged more outward at bending positions of the respective first inlet paths 10 have longer channel lengths than those arranged more inward. Here, in each first inlet path 10, equivalent diameters of the respective portions are properly set according to the channel length, whereby total pressure losses of the respective first inlet paths 10 are set to an equal value.

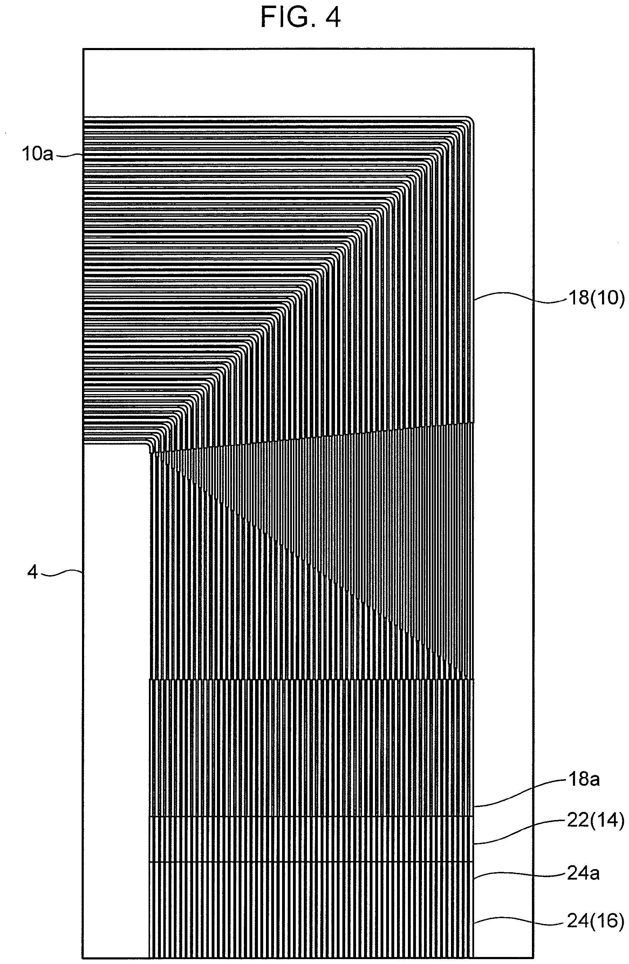

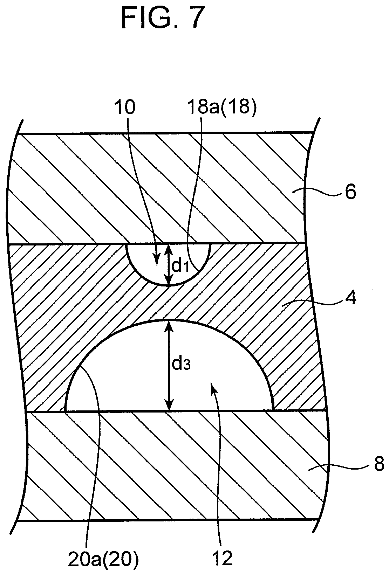

Specifically, each first inlet path 10 has a downstream end portion having a semicircular cross sectional shape in a cross section orthogonal to a flowing direction of the first reactant as shown in FIG. 7. Each first inlet path 10 includes portions different in equivalent diameter by a difference in the width as shown in FIG. 4. The longer channel length the first inlet path 10 has, the larger pressure loss it has as compared with the first inlet paths 10 having shorter channel lengths. By suitably setting the equivalent diameters of the respective portions of the first inlet paths 10, pressure loss differences resulting from channel length differences are eliminated to make the pressure losses of the respective first inlet paths 10 uniform. Specifically, smaller equivalent diameter portions of the first inlet paths 10 have larger pressure losses, whereas larger equivalent diameter portions thereof have smaller pressure losses. Thus, the larger equivalent diameter portions, i.e. larger width portions are increased and the smaller equivalent diameter portions, i.e. smaller width portions are decreased for the first inlet paths 10 having longer channel lengths, whereby the total pressure losses of the respective first inlet paths 10 are made more uniform. Since the pressure losses of the respective first inlet paths 10 are made more uniform, the flow rate of the first reactant distributed among the respective first inlet paths 10 from the reactant supply unit is made uniform.

Each second inlet path 12 has an inlet opening 12a at one longitudinal end of the first channel forming body 1a. Each second inlet path 12 extends straight in the longitudinal direction of the first channel forming body 1a from the inlet opening 12a. Each second inlet path 12 is arranged to overlap the portion of the corresponding first inlet path 10 extending in the longitudinal direction of the first channel forming body 1a in a thickness direction of the first channel forming body 1a and arranged in parallel with this portion. A second reactant supply unit 50b (see FIG. 1) is connected with the inlet openings 12a of the respective second inlet paths 12. The second reactant is introduced to the respective second inlet paths 12 from the second reactant supply unit 50b while being distributed among them.

The respective second inlet paths 12 are arranged side by side at equal intervals in the width direction of the first channel forming body 1a. Each second inlet path 12 has a semicircular cross-sectional shape in a cross section orthogonal to a flowing direction of the second reactant as shown in FIG. 7. Each second inlet path 12 has a constant width over the entire length and a constant equivalent diameter over the entire length. The respective second inlet paths 12 have equal channel length and equivalent diameter. Thus, total pressure losses of the respective second inlet paths 12 are equal. Since the pressure losses of the respective second inlet paths 12 are equal, the flow rate of the second reactant distributed among and flowing into the respective second inlet paths 12 from the second reactant supply unit 50b is made uniform.

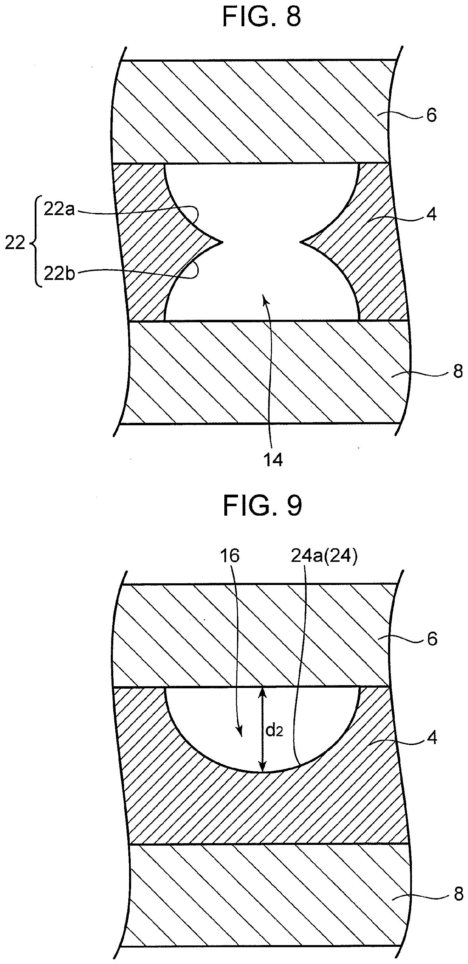

Each junction channel 14 is connected with downstream sides of the corresponding first and second inlet paths 10, 12. Each junction channel 14 extends straight in the same direction as the portion of the first inlet path 10 extending in the longitudinal direction of the first channel forming body 1a and the second inlet path 12. Specifically, the portion of the corresponding first inlet path 10 extending in the longitudinal direction of the first channel forming body 1a and the corresponding second inlet path 12 join into the junction channel 14 in the same direction. This junction channel 14 is for joining the first reactant flowing via the first inlet path 10 and the second reactant flowing via the second inlet path 12 while permitting the flows of these reactants in the longitudinal direction of the first channel forming body 1a. Each junction channel 14 has such a cross-sectional shape obtained by connecting two semicircles near tops of their arcs in a cross section orthogonal to the longitudinal direction as shown in FIG. 8. Each junction channel 14 has an equivalent diameter larger than those of the first inlet path 10 and the second inlet path 12.

Each reaction channel 16 is connected with a downstream side of the corresponding junction channel 14 and extends straight in the same direction as the junction channel 14. This reaction channel 16 is for reacting the first and second reactants joined in the junction channel 14 with each other while permitting the flows of these reactants in the longitudinal direction of the first channel forming body 1a. The respective reaction channels 16 are formed in one surface of the base plate 4 of the first channel forming body 1a. The respective reaction channels 16 are arranged side by side at equal intervals in the width direction of the first channel forming body 1a. Each reaction channel 16 has a semicircular cross-sectional shape in a cross section orthogonal to the longitudinal direction as shown in FIG. 9. Each reaction channel 16 has a constant width over the entire length and a constant equivalent diameter over the entire length. The respective reaction channels 16 have equal channel length and equal equivalent diameter. Thus, pressure losses of the respective reaction channels 16 are equal.

In this embodiment, first inlet grooves 18 for forming the respective first inlet paths 10, second inlet grooves 20 for forming the respective second inlet paths 12, junction holes 22 for forming the respective junction channels 14 and reaction grooves 24 for forming the respective reaction channels 16 are respectively formed in the base plate 4. The respective channels 2 in the first channel forming body 1a are formed only by covering openings of the respective grooves 18, 20 and 24 and openings of the respective junction holes 22 by the sealing members 6, 8.

Specifically, a plurality of first inlet grooves 18 (see FIG. 4) are formed in parallel and side by side in the one surface of the base plate 4. The openings of the respective first inlet grooves 18 formed in the one surface of the base plate 4 are sealed by the first sealing member 6, whereby the respective first inlet paths 10 are formed. Accordingly, the respective first inlet paths 10 are arranged in parallel and side by side in the one surface side of the base plate 4 in the first channel forming body 1a. Further, each first inlet groove 18 includes a first inlet groove connecting portion 18a connected with the junction hole 22 to be described later. This first inlet groove connecting portion 18a has a depth d1 (see FIG. 6). This depth d1 is embraced by the concept of a first depth of the present invention. Each first inlet groove 18 has the uniform depth d1 over the entire length. The first inlet groove connecting portion 18a has a semicircular cross-sectional shape in a cross section orthogonal to the flowing direction of the first reactant. A portion of each first inlet groove 18 other than the first inlet groove connecting portion 18a and corresponding to the portions of the first inlet path 10 having different equivalent diameters has a different width while having the constant depth d1.

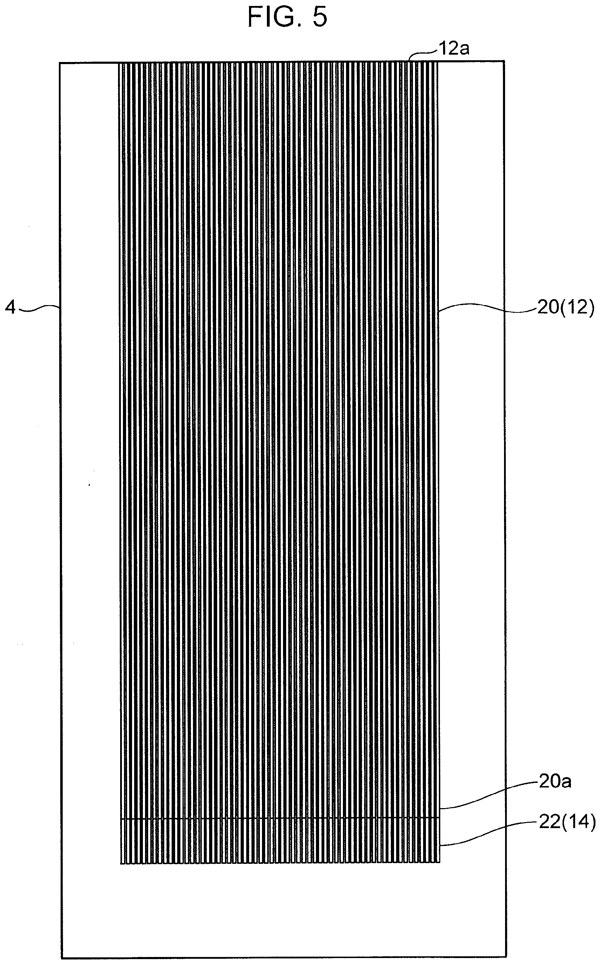

A plurality of second inlet grooves 20 (see FIG. 5) are formed in parallel and side by side in the other surface of the base plate 4. The openings of the respective second inlet grooves 20 formed in the other surface of the base plate 4 are sealed by the second sealing member 8 to form the respective second inlet paths 12. Accordingly, the respective second inlet paths 12 are arranged side by side and in parallel in the other surface side of the base plate 4 in the first channel forming body 1a. Further, each second inlet groove 20 includes a second inlet groove connecting portion 20a connected with the junction hole 22 to be described later. This second inlet groove connecting portion 20a has a depth d3 (see FIG. 6). This depth d3 is embraced by the concept of a third depth of the present invention. The depth d3 is larger than a difference between the thickness of the base plate 4 and a depth d2 of the reaction groove 24 to be described later and smaller than a difference between the thickness of the base plate 4 and the depth d1 of the first inlet groove 18. Each second inlet groove 20 has the uniform depth d3 over the entire length. Each second inlet groove 20 has a semicircular cross-sectional shape in a cross section orthogonal to the flowing direction of the second reactant.

Each junction channel 14 is formed by sealing both openings of each junction hole 22 formed in the base plate 4. Specifically, a plurality of junction holes 22 are formed side by side in the base plate 4 in the width direction of the base plate 4. Each junction hole 22 penetrates the base plate 4 from the one surface to the other surface between the corresponding first and second inlet grooves 18, 20 and the reaction groove 24 to be described later and corresponding to the inlet grooves 18, 20. Each junction hole 22 interconnects the downstream ends of the corresponding inlet grooves 18, 20 and an upstream end of the corresponding reaction groove 24. The opening of each junction hole 22 formed in the one surface of the base plate 4 is sealed by the first sealing member 6 and the opening thereof formed in the other surface of the base plate 4 is sealed by the second sealing member 8, whereby each junction channel 14 is formed. Each junction hole 22 has a cross-sectional shape corresponding to the cross-sectional shape of the junction channel 14. Specifically, each junction hole 22 has such a cross-sectional shape obtained by connecting two semicircles near tops of their arcs in a cross section orthogonal to the longitudinal direction.

A plurality of reaction grooves 24 (see FIG. 4) are formed in parallel and side by side in the one surface of the base plate 4. The openings of the respective reaction grooves 24 formed in the one surface of the base plate 4 are sealed by the first sealing member 6 to form the respective reaction channels 16. Each reaction groove 24 includes a reaction groove connecting portion 24a connected with the junction hole 22. This reaction groove connecting portion 24a has the depth d2 (see FIG. 6). This depth d2 is embraced by the concept of a second depth of the present invention. This depth d2 is larger than the depth d1 of the first inlet groove 18 and equal to the depth d3 of the second inlet groove 20. The sum of the depths d2, d3 is set to be larger than the thickness of the base plate 4. Each reaction groove 24 has the uniform depth d3 over the entire length. Each reaction groove 24 has a semicircular cross-sectional shape in a cross section orthogonal to the longitudinal direction thereof.

The bottom surfaces of the reaction groove connecting portions 24a are closer to the other surface of the base plate 4 than those of the first inlet groove connecting portions 18a since the depth d2 of the reaction groove connecting portions 24a is larger than the depth d1 of the first inlet grooves 18 as described above. Therefore, steps are formed between the bottom surfaces of the first inlet groove connecting portions 18a and the bottom surfaces of the reaction groove connecting portions 24a. Since the steps are formed between the bottom surfaces of the first inlet groove connecting portions 18a and the bottom surfaces of the reaction groove connecting portions 24a, the first reactant flows toward the downstream side while moving from the one surface of the base plate 4 toward the other surface of the base plate 4 in paths from the first inlet groove connecting portions 18a to the reaction groove connecting portions 24a via the junction holes 22. On the other hand, since the second inlet grooves 20 are formed in the other surface of the base plate 4 and the reaction grooves 24 are formed in the one surface of the base plate 4, paths reaching from the second inlet grooves 20 to the reaction grooves 24 via the junction holes 22 are bent and the second reactants flowing in these paths flow toward the downstream sides while moving from the other surface of the base plate 4 toward the one surface of the base plate 4.

Each second channel forming body 1b is internally formed with a plurality of heating medium channels (not shown) for permitting the flow of the heating medium as described above. These plurality of heating medium channels are arranged at equal intervals in the second channel forming body 1b in the width direction of the second channel forming body 1b. The respective heating medium channels include unillustrated inlet openings in a surface opposite to the surface formed with the inlet openings 12a of the second inlet paths 12 in the channel device S. The respective heating medium channels extend straight in the width direction of the second channel forming body 1b from the inlet openings, are bent by 90 degrees, and extend straight in the longitudinal direction of the second channel forming body 1b. Portions of the respective heating medium channels extending in the longitudinal direction of the second channel forming body 1b are arranged at positions corresponding to the portions of the first inlet paths 10 extending in the longitudinal direction of the first channel forming body 1a and the respective reaction channels 16.

This second channel forming body 1b is made up of a heating medium channel base plate 26 and a sealing member 28. These heating medium channel base plate 26 and sealing member 28 are flat boards of the same rectangular shape as the base plate 4, the first sealing member 6 and the second sealing member 8, and the sealing member 28 doubles as the second sealing member 8. The sealing member 28 is bonded to a surface of the heating medium channel base plate 26 while covering this surface. The respective heating medium channels are formed by sealing openings of grooves 32 (see FIG. 2) formed in the surface of the heating medium channel base plate 26 by the sealing member 28.

A heating member supply unit 50c (see FIG. 1) is connected with the inlet openings of the respective heating medium channels. The heating medium is introduced into the respective heating medium channels from the heating medium supply unit 50c while being distributed. Thus, heat exchange is carried out between the heating medium flowing in the respective heating medium channels and the first and second reactants flowing in the respective reaction channels 16 of the first channel forming body 1a, thereby promoting the reaction of the first and second reactants in the respective reaction channels 16.

Next, a method for manufacturing the reactor of this embodiment is described.

In the method for manufacturing the reactor of this embodiment, a plurality of channels 2 are formed in the first channel forming body 1a and the first channel forming body 1a is formed such that each channel 2 is made up of the first inlet path 10, the second inlet path 12, the junction channel 14 and the reaction channel 16.

Specifically, a plurality of said first inlet grooves 18, a plurality of said reaction grooves 24 and portions 22a (see FIG. 8) of a plurality of said junction holes 22 having a specified depth from the one surface of the base plate 4 are respectively formed in the one surface of the base plate 4 by photoetching, and a plurality of said second inlet grooves 20 and portions 22b (see FIG. 8) of a plurality of said junction holes 22 having a specified depth from the other surface of the base plate 4 are respectively formed in the other surface of the base plate 4 by photoetching.

At this time, both surfaces of the base plate 4 are smoothed and cleaned and, then, photoresist is applied to these both surfaces of the base plate 4. Areas on one surface of the base plate 4 other than formation areas of the respective first inlet grooves 18, the respective reaction grooves 24 and the respective junction holes 22 are exposed with light via a photomask. Areas on the other surface of the base plate 4 other than formation areas of the respective second inlet grooves 20 and the respective junction holes 22 are exposed with light via another photomask. Thereafter, parts of the photoresist not exposed with light are removed from the both surfaces of the base plate 4 so as to expose the formation areas of the respective first inlet grooves 18, the respective second inlet grooves 20, the respective reaction grooves 24 and the respective junction holes 22.

Next, only the formation area of the first inlet grooves 18 on the one surface of the base plate 4 is covered by a covering member such as a masking tape. Thereafter, an etching liquid is sprayed onto the both surfaces of the base plate 4 to simultaneously apply etching to the both surfaces. At this time, the formation area of the respective first inlet grooves 18 covered by the covering member is not etched and only the exposed formation areas of the respective second inlet grooves 20, the respective reaction grooves 24 and the respective junction holes 22 are etched. After the formation area of the respective reaction grooves 24 and that of the respective junction holes 22 are etched to a depth corresponding to a difference between the above depth d2 (= the above depth d3) and the above depth d1 from the one surface of the base plate 4 and the formation area of the respective second inlet grooves 20 and that of the respective junction holes 22 are etched to a similar depth from the other surface of the base plate 4, etching is temporarily stopped.

Thereafter, the covering member is removed and the formation area of the respective first inlet grooves 18 is exposed, and then etching is resumed. In this resumed etching process, at the same time as the formation area of the respective first inlet grooves 18, that of the respective reaction grooves 24 and that of the respective junction holes 22 are etched by the depth d1 from the one surface of the base plate 4, the formation area of the respective second inlet grooves 20 and that of the respective junction holes 22 are etched by a similar depth from the other surface of the base plate 4. In this way, the respective first inlet grooves 18 of the depth d1 from the one surface of the base plate 4 are formed and the formation area of the respective second inlet grooves 20 and that of the respective reaction grooves 24 are etched to a depth of (d2-d1)+d1=d2. By etching the formation area of the respective reaction grooves 24 and the formation area of the respective second inlet grooves 20, the respective reaction grooves 24 of the depth d2 from the one surface of the base plate 4 and the respective second inlet grooves 20 of the depth d2=d3 from the other surface of the base plate 4 are formed. Further, the formation areas of the respective junction holes 22 are etched to the same depth d2 as the reaction grooves 24 from the one surface of the base plate 4 and etched to the same depth d3 as the second inlet grooves 20 from the other surface of the base plate 4. In this way, portions 22a etched to the depth d2 from the one surface of the base plate 4 and portions 22b etched to the depth d3 from the other surface of the base plate 4 are connected, so that the respective junction holes 22 penetrate the base plate 4. In other words, the respective junction holes 22 are formed utilizing etching to form the respective reaction grooves 24 and etching to form the respective second inlet grooves 20. Thereafter, the base plate 4 is cleaned and resist films are removed.

In another process, a plurality of said grooves 32 are formed in the heating medium channel base plate 26 forming the second channel forming body 1b. Specifically, the plurality of grooves 32 are formed in one surface of the heating medium channel base plate 26 by photoetching similar to the above.

Finally, the base plates 4 and the heating medium channel base plates 26 etched as above, the first sealing members 6 and the second sealing members 8 (sealing member 28) are placed one above another as shown in FIG. 1 and united by diffusion bonding to fabricate the channel device S.

Other constituent members such as the first reactant supply unit 50a, the second reactant supply unit 50b and the heating medium supply unit 50c are attached to the thus fabricated channel device S to manufacture the reactor of this embodiment.

Next, a reaction method using the reactor of this embodiment is described.

In this reaction method, the first reactant is introduced into the first inlet paths 10 of the respective channels 2 from the first reactant supply unit 50a and the second reactant is introduced into the second inlet paths 12 of the respective channels 2 from the second reactant supply unit 50b. The first reactant flows in the respective first inlet paths 10 while being distributed at a uniform flow rate since the total pressure losses of the respective first inlet paths 10 are made uniform. The second reactant flows in the respective second inlet paths 12 while being distributed at a uniform flow rate since the total pressure losses of the respective second inlet paths 12 are made uniform.

The first reactant having passed through the first inlet paths 10 and the second reactant having passed through the second inlet paths 12 join into the junction channels 14 while moving in directions toward each other, and are uniformly mixed. The joined two reactants flow into the reaction channels 16 from the junction channels 14 and react with each other while flowing toward the downstream sides in the reaction channels 16. As a result, a specified reaction product is manufactured.

As described above, in this embodiment, since the bottom surfaces of the reaction groove connecting portions 24a are located closer to the other surface of the base plate 4 than the bottom surfaces of the first inlet groove connecting portions 18a, the first and second reactants can be more uniformly mixed as compared with the case where the bottom surfaces of the reaction groove connecting portions 24a and the bottom surfaces of the first inlet groove connecting portions 18a are flush with each other. Specifically, in this embodiment, the first reactant flows toward the downstream side while moving from the one surface of the base plate 4 toward the other surface of the base plate 4 since the bottom surfaces of the reaction groove connecting portions 24a are located closer to the other surface of the base plate 4 than the bottom surfaces of the first inlet groove connecting portions 18a. On the other hand, in this embodiment, the paths reaching from the second inlet grooves 20 to the reaction grooves 24 via the junction holes 22 are bent since the second inlet grooves 20 are formed in the other surface of the base plate 4 and the reaction grooves 24 are formed in the one surface of the base plate 4. Therefore, the second reactant flowing in these paths flows toward the downstream side while moving from the other surface of the base plate 4 toward the one surface of the base plate 4. Thus, in this embodiment, the first and second reactants join and flow toward the downstream side while moving in the directions toward each other, thereby the first and second reactants are more sufficiently mixed as compared with the case where the bottom surfaces of the reaction groove connecting portions 24a and the bottom surfaces of the first inlet groove connecting portions 18a are flush with each other and the second reactant joins the straight and smooth flow of the first reactant halfway. As a result, in this embodiment, the mixing uniformity of the both reactants can be improved.

Further, in this embodiment, the first inlet grooves 18, the second inlet grooves 20, the reaction grooves 24 and the junction holes 22 are formed in the base plate 4 and the first inlet paths 10, the second inlet paths 12, the junction channels 14 and the reaction channels 16 are formed only by covering the openings of the first grooves 18, the openings of the reaction grooves 24, the one openings of the junction holes 22 formed in the base plate 4 by the first sealing member 6 and covering the openings of the first grooves 18, the openings of the reaction grooves 24, the other openings of the junction holes 22 formed in the base plate 4 by the second sealing member 8. Thus, in this embodiment, it is sufficient only to etch the base plate 4 for forming the first inlet grooves 18, the second inlet grooves 20, the reaction grooves 24 and the junction holes 22 and it is not necessary to etch the both sealing members 6, 8. Thus, as compared with the conventional construction that needs to etch the both sealing members such that the parts of the both sealing members corresponding to the reaction channels project in addition to etching the base plate 4, the number of etching steps can be reduced. Further, in this embodiment, the channels 2 are formed only by covering the openings of the respective grooves 18, 20 and 24 and those of the junction holes 22 formed in the base plate 4 by the sealing members 6, 8 bonded to the base plate 4. Thus, a cumbersome operation of bonding the both sealing members 6, 8 to the base plate 4 while positioning them with respect to the base plate 4 can be eliminated. Therefore, in this embodiment, it can be prevented to make the manufacturing process of the reactor cumbersome while improving the mixing uniformity of the reactants in the reactor.

Further, in this embodiment, the portions 22a etched to the depth d2 from the one surface of the base plate 4 and the portions 22b etched to the depth d3 from the other surface of the base plate 4 are connected so that the respective junction holes 22 penetrate the base plate 4 by etching the formation areas of the junction holes 22 to the depth d2 from the one surface of the base plate 4 at the same time as forming the reaction grooves 24 and etching the formation areas of the junction holes 22 to the depth d3 from the other surface of the base plate 4 at the same time as forming the second inlet grooves 20. Therefore, the junction holes 22 can be formed utilizing etching to form the reaction grooves 24 and etching to form the second inlet grooves 20. As a result, in this embodiment, it is not necessary to perform a special etching step of forming the junction holes 22 or a step of forming the junction holes 22 by laser machining or the like. Thus, the manufacturing process of the reactor can be simplified.

It should be appreciated that the embodiment disclosed this time is illustrative and not restrictive in all points. The scope of the present invention is indicated not by the above description of the embodiment, but by appended claims and embraces all changes within the meaning and scope equivalent to the appended claims.

For example, the first inlet paths 10, the second inlet paths 12, the junction channels 14 and the reaction channels 16 may be formed to have shapes and/or arrangements other than the above in the first channel forming body 1a.

Specifically, the respective first inlet paths 10 may be formed to extend straight in the longitudinal direction of the first channel forming body 1a. Further, the respective second inlet paths 12 may be formed to have bent shapes like the first inlet paths 10. Furthermore, the depth d3 of the second inlet grooves 20 for forming the second inlet paths 12 may be smaller than the depth d1 of the first inlet grooves 18.

The reactor needs not necessarily include a plurality of first channel forming bodies 1a and a plurality of second channel forming bodies 1b placed one over another as described above and may include only a single first channel forming body 1a.

Only a single channel 2 may be formed in the first channel forming bodies 1a.

The respective first inlet paths 10 (the respective first inlet grooves 18) may extend in different directions. The respective second inlet paths 12 (the respective second inlet grooves 20) may extend in different directions. The respective reaction channels 16 (the respective reaction grooves 24) may extend in different directions.

In the above embodiment, the portions of the first inlet grooves 18, the second inlet grooves 20 and the reaction grooves 24 having the semicircular cross-sectional shapes may each have such a cross-sectional shape that a bottom surface part is a straight portion parallel to the base plate 4 and arcuate parts are connected at the opposite sides of the straight portion.

Although the depth d2 of the reaction grooves 24 and the depth d3 of the second inlet grooves 20 are equal in the above embodiment, these depths d2 and d3 may differ provided that the sum thereof is larger than the thickness of the base plate 4.

For example, if the depth d2 is larger than the depth d3, the first inlet grooves 18, the second inlet grooves 20, the reaction grooves 24 and the junction holes 22 are formed in the base plate 4 by the following etching process.

Specifically, similar to the above embodiment, areas of the both surfaces of the base plate 4 other than the formation areas of the respective first inlet grooves 18, the respective second inlet grooves 20, the respective reaction grooves 24 and the respective junction holes 22 are covered by photoresist exposed to light.

Subsequently, the formation area of the first inlet groove 18 on the one surface of the base plate 4 and the formation area of the second inlet grooves 20 on the other surface of the base plate 4 are covered by covering members such as masking tapes and then etching is simultaneously applied to the both surfaces of the base plate 4. At this time, after the exposed formation areas of the respective reaction grooves 24 and the respective junction holes 22 are etched to a depth (d2-d3) equivalent to a difference between the depths d2 and d3 from the one surface of the base plate 4 and the formation area of the respective junction holes 22 is etched to a similar depth from the other surface of the base plate 4. Thereafter, the covering member covering the formation area of the second inlet grooves 20 is removed.

Thereafter, at the same time as the exposed formation areas of the respective reaction grooves 24 and the respective junction holes 22 are etched by a depth (d3-d1) equivalent to a difference between the depths d3 and d1 from the one surface of the base plate 4, the formation areas of the respective second inlet grooves 20 and the respective junction holes 22 are etched by a similar depth from the other surface of the base plate 4. Thereafter, the covering member covering the formation area of the first inlet grooves 18 is removed.

Thereafter, at the same time as the exposed formation areas of the respective first inlet grooves 18, the respective reaction grooves 24 and the respective junction holes 22 are etched by the depth d1 from the one surface of the base plate 4, the formation areas of the respective second inlet grooves 20 and the respective junction holes 22 are etched by a similar depth from the other surface of the base plate 4. In this way, the respective first inlet grooves 18 of the depth d1 from the one surface of the base plate 4 are formed. The formation area of the respective reaction grooves 24 is etched to a depth (d2-d3)+(d3-d1)+d1 = d2 from the one surface of the base plate 4, as a result, the respective reaction grooves 24 of the depth d2 from the one surface of the base plate 4 are formed. Further, the formation areas of the respective second inlet grooves 20 are etched to a depth (d3-d1)+d1 = d3 from the other surface of the base plate 4. In this way, the respective second inlet grooves 20 of the depth d3 from the other surface of the base plate 4 are formed. Further, the formation area of the respective junction holes 22 is etched to the same depth d2 as the reaction grooves 24 from the one surface of the base plate 4 while being etched to the same depth d3 as the second inlet grooves 20 from the other surface of the base plate 4. In this way, portions etched to the depth d2 from the one surface of the base plate 4 and portions etched to the depth d3 from the other surface of the base plate 4 are interconnected, whereby the respective junction holes 22 penetrate the base plate 4. In other words, in this construction as well, the respective junction holes 22 are formed utilizing etching to form the respective reaction grooves 24 and etching to form the respective second inlet grooves 20.

Although the both surfaces of the base plate 4 are simultaneously etched in the above embodiment, the one and the other surfaces of the base plate 4 may be separately etched.

In the process of etching the base plate 4, at least the first inlet groove connecting portions 18a of the first inlet grooves 18 may be formed by etching the one surface of the base plate 4 to the depth d1 and at least the reaction groove connecting portions 24a of the reaction grooves 24 may be formed by etching the one surface of the base plate 4 to the depth d2. Further, in this process, at least second inlet groove connecting portions 20a of the second inlet grooves 20 may be formed by etching the other surface of the base plate 4 to the depth d3. In other words, portions of the first inlet grooves 18 other than the first inlet groove connecting portions 18a may be formed to have a depth different from the depth d1, portions of the reaction grooves 24 other than the reaction groove connecting portions 24a may be formed to have a depth different from the depth d2, and portions of the second inlet grooves 20 other than the second inlet groove connecting portions 20a may be formed to have a depth different from the depth d3. In this case, the junction holes 22 may be formed utilizing etching to form the reaction groove connecting portions 24a of the reaction grooves 24 and etching to form the second inlet groove connecting portions 20a of the second inlet grooves 20.

### (Summary of the Embodiment)

The above embodiment is summarized as follows.

Specifically, a reactor according to the above embodiment is for reacting first and second reactants while permitting the flows of the reactants and comprises a channel forming body internally formed with a channel including a first inlet path having the first reactant introduced thereinto, a second inlet path having the second reactant introduced thereinto, a junction channel connected with a downstream side of the first inlet path and that of the second inlet path for causing the first reactant flowing via the first inlet path and the second reactant flowing via the second inlet path to join, and a reaction channel connected with a downstream side of the junction channel for reacting the both reactants joined in the junction channel with each other while permitting the flows of the reactants, wherein: the channel forming body includes a base plate, a first sealing member bonded to one surface of the base plate while covering the one surface, and a second sealing member bonded to the other surface of the base plate while covering the other surface; a first inlet groove for forming the first inlet path and a reaction groove for forming the reaction channel are formed in the one surface of the base plate while a second inlet groove for forming the second inlet path is formed in the other surface of the base plate; the base plate is formed with a junction hole for forming the junction channel, the junction hole penetrating the base plate from the one surface to the other surface between the first and second inlet grooves and the reaction groove so as to interconnect downstream ends of the inlet grooves and an upstream end of the reaction groove; and the reaction groove has a reaction groove connecting portion which is connected with the junction hole and which has a uniform depth along its entire length, the first inlet groove has a first inlet groove connecting portion which is connected with the junction hole and which has a uniform depth along its entire length, the second inlet groove has a second inlet groove connecting portion which is connected with the junction hole and which has a uniform depth along its entire length, and the depth of the reaction groove connecting portion is larger than the depth of the first inlet groove connecting portion.

This reactor can be formed by a method for manufacturing a reactor including a channel forming body internally formed with a channel for permitting the flows of a first reactant and a second reactant, the method comprising: a channel forming body forming step of forming the channel forming body such that the channel includes a first inlet path having the first reactant introduced thereinto, a second inlet path having the second reactant introduced thereinto, a junction channel connected with a downstream side of the first inlet path and a downstream side of the second inlet path for causing the first reactant flowing via the first inlet path and the second reactant flowing via the second inlet path to join, and a reaction channel connected with a downstream side of the junction channel for reacting the both reactants joined in the junction channel with each other while permitting the flows of the reactants, wherein the channel forming body forming step includes: a first inlet groove forming step of forming a first inlet groove for forming the first inlet path in one surface of a base plate by etching; a reaction groove forming step of forming a reaction groove for forming the reaction channel in the one surface of the base plate by etching; a second inlet groove forming step of forming a second inlet groove for forming the second inlet path in the other surface of the base plate by etching; a junction hole forming step of forming a junction hole for forming the junction channel by etching such that the junction hole penetrates the base plate so as to connect downstream ends of the first and second inlet grooves to each other and connect the downstream ends and an upstream end of the reaction groove; a first sealing step of bonding a first sealing member to the one surface of the base plate to cover the one surface, thereby sealing openings of the first inlet groove, the reaction groove and the junction hole in the one surface; and a second sealing step of bonding a second sealing member to the other surface of the base plate to cover the other surface, thereby sealing openings of the second inlet groove and the junction hole in the other surface; the first inlet groove forming step includes a first inlet groove connecting portion forming step of forming at least a portion of the first inlet groove which portion is connected with the junction hole by etching the one surface of the base plate to a uniform first depth along the entire length of said portion of the first inlet groove; and the reaction groove forming step includes a reaction groove connecting portion forming step of forming at least a portion of the reaction groove which portion is connected with the junction hole by etching the one surface of the base plate to a uniform second depth along the entire length of said portion of the reaction groove, and the second inlet groove forming step includes a second inlet groove connecting portion forming step of forming at least a portion of the second inlet groove which portion is connected with the junction hole by etching the other surface of the base plate to a uniform third depth along the entire length of said portion of the second inlet groove, wherein the second depth is larger than the first depth.

According to the above reactor and the method for manufacturing this reactor, since the bottom surface of the portion of the reaction groove connected with the junction hole is located closer to the other surface of the base plate than the bottom surface of the portion of the first inlet groove connected with the junction hole, the first and second reactants can be more uniformly mixed as compared with the case where the bottom surface of the portion of the reaction groove connected with the junction hole and the bottom surface of the portion of the first inlet groove connected with the junction hole are flush with each other. Specifically, in this arrangement, the first reactant flows toward the downstream side while moving from the one surface of the base plate toward the other surface of the base plate since the bottom surface of the portion of the reaction groove connected with the junction hole is located closer to the other surface of the base plate than the bottom surface of the portion of the first inlet groove connected with the junction hole. On the other hand, in this arrangement, the path reaching from the second inlet groove to the reaction groove via the junction hole is bent since the second inlet groove is formed in the other surface of the base plate and the reaction groove is formed in the one surface of the base plate. Therefore, the second reactant flowing in this path flows toward the downstream side while moving from the other surface of the base plate toward the one surface of the base plate. Thus, in this arrangement, the first and second reactants join and flow toward the downstream side while moving in approaching directions each other, thereby the first and second reactants are more sufficiently mixed as compared with the case where the bottom surface of the portion of the reaction groove connected with the junction hole and the bottom surface of the portion of the first inlet groove connected with the junction hole are flush with each other and the second reactant joins the straight and smooth flow of the first reactant halfway. As a result, the mixing uniformity of the both reactants can be improved.

Further, in this arrangement, the first inlet groove, the second inlet groove, the reaction groove and the junction hole are formed in the base plate and the first inlet path, the second inlet path, the junction channel and the reaction channel are formed only by covering the opening of the first groove, the opening of the reaction groove, the one opening of the junction hole formed in the base plate by the first sealing member and covering the opening of the first groove, the opening of the reaction groove, the other opening of the junction hole formed in the base plate by the second sealing member. Thus, in this arrangement, it is sufficient only to etch the base plate for forming the first inlet groove, the second inlet groove, the reaction groove and the junction hole and it is not necessary to etch the both sealing members. Thus, as compared with the conventional construction that needs to etch the both sealing members such that the parts of the both sealing members corresponding to the reaction channel project in addition to etching the base plate, the number of etching steps can be reduced. Further, in this arrangement, since the channel is formed only by covering the openings of the respective grooves and the junction hole formed in the base plate by the sealing members bonded to the base plate, a cumbersome operation of bonding the both sealing members to the base plate while positioning them with respect to the base plate can be eliminated. Therefore, in this arrangement, it can be prevented to make the manufacturing process of the reactor cumbersome. Thus, in this arrangement, it can be prevented to make the manufacturing process of the reactor cumbersome while improving the mixing uniformity of the reactants in the reactor.

In the above method for manufacturing a reactor, the second inlet groove forming step preferably includes a second inlet groove connecting portion forming step of forming at least a portion of the second inlet groove connected with the junction hole by etching the other surface of the base plate to a uniform third depth along the entire length of said portion of the second inlet groove, wherein the third depth is larger than a difference between the thickness of the base plate and the second depth and smaller than a difference between the thickness of the base plate and the first depth; the junction hole forming step preferably includes a first step to be performed simultaneously with the reaction groove connecting portion forming step and adapted to etch a formation area of the junction hole on the one surface of the base plate to the second depth, and a second step to be performed simultaneously with the second inlet groove connecting portion forming step and adapted to etch a formation area of the junction hole on the other surface of the base plate to the third depth; and a portion etched to the second depth in the first step and a portion etched to the third depth in the second step are preferably connected so that the junction hole penetrates the base plate.

According to this arrangement, the junction hole can be formed utilizing etching in the reaction groove connecting portion forming step and etching in the second inlet groove connecting portion forming step. Therefore, it is not necessary to perform a special etching step of forming the junction hole or a step of forming the junction hole by laser machining or the like. Thus, the manufacturing process of the reactor can be simplified.

As described above, according to the above embodiment, it can be prevented to make the manufacturing process of the reactor cumbersome while improving the mixing uniformity of the reactants in the reactor.

## Claims

1. A reactor for reacting first and second reactants while permitting the flows of the reactants, comprising:
a channel forming body (1a, 1b) internally formed with a channel (2) including a first inlet path (10) having the first reactant introduced thereinto, a second inlet path (12) having the second reactant introduced thereinto, a junction channel (14) connected with a downstream side of the first inlet path (10) and a downstream side of the second inlet path (12) for causing the first reactant flowing via the first inlet path (10) and the second reactant flowing via the second inlet path (12) to join, and a reaction channel (16) connected with a downstream side of the junction channel (14) for reacting the both reactants joined in the junction channel (14) with each other while permitting the flows of the reactants, wherein:
the channel forming body (1a, 1b) includes a base plate (4), a first sealing member (6) bonded to one surface of the base plate (4) while covering the one surface, and a second sealing member (8) bonded to the other surface of the base plate (4) while covering the other surface;
a first inlet groove (18) for forming the first inlet path (10) and a reaction groove (24) for forming the reaction channel (16) are formed in the one surface of the base plate (4) while a second inlet groove (20) for forming the second inlet path (12) is formed in the other surface of the base plate (4);
the base plate (4) is formed with a junction hole (22) for forming the junction channel (14), the junction hole (22) penetrating the base plate from the one surface to the other surface between the first and second inlet grooves (18, 20) and the reaction groove (24) so as to interconnect downstream ends of the inlet grooves (18, 20) and an upstream end of the reaction groove (24);
the reaction groove (24) has a reaction groove connecting portion (24a) which is connected with the junction hole (22) and which has a uniform depth (d2) along its entire length,
the first inlet groove (18) has a first inlet groove connecting portion (18a) which is connected with the junction hole (22) and which has a uniform depth (d1) along its entire length, and
the second inlet groove (20) has a second inlet groove connecting portion (20a) which is connected with the junction hole (22) and which has a uniform depth (d3) along its entire length, **characterized in that**
the depth (d2) of the reaction groove connecting portion (24a) is larger than the depth (d1) of the first inlet groove connecting portion (18a).

2. A method for manufacturing a reactor comprising a channel forming body (1a, 1b) internally formed with a channel (2) for permitting the flows of a first reactant and a second reactant, comprising:
a channel forming body forming step of forming the channel forming body (1a, 1b) such that the channel (2) includes a first inlet path (10) having the first reactant introduced thereinto, a second inlet path (12) having the second reactant introduced thereinto, a junction channel (14) connected with a downstream side of the first inlet path (10) and a downstream side of the second inlet path (12) for causing the first reactant flowing via the first inlet path (10) and the second reactant flowing via the second inlet path (12) to join, and a reaction channel (16) connected with a downstream side of the junction channel (14) for reacting the both reactants joined in the junction channel (14) with each other while permitting the flows of the reactants,
wherein the channel forming body forming step includes:
a first inlet groove forming step of forming a first inlet groove (18) for forming the first inlet path (10) in one surface of a base plate (4) by etching;
a reaction groove forming step of forming a reaction groove (24) for forming the reaction channel (16) in the one surface of the base plate (4) by etching;
a second inlet groove forming step of forming a second inlet groove (20) for forming the second inlet path (12) in the other surface of the base plate (4) by etching;
a junction hole forming step of forming a junction hole (22) for forming the junction channel (14) by etching such that the junction hole (22) penetrates the base plate (4) so as to connect downstream ends of the first and second inlet grooves (18, 20) to each other and connect the downstream ends and an upstream end of the reaction groove (24);
a first sealing step of bonding a first sealing member (6) to the one surface of the base plate (4) to cover the one surface, thereby sealing openings of the first inlet groove (18), the reaction groove (24) and the junction hole (22) in the one surface; and
a second sealing step of bonding a second sealing member (8) to the other surface of the base plate (4) to cover the other surface, thereby sealing openings of the second inlet groove (20) and the junction hole (22) in the other surface;
the first inlet groove forming step includes a first inlet groove connecting portion forming step of forming at least a portion of the first inlet groove (18) which portion is connected with the junction hole (22) by etching the one surface of the base plate (4) to a uniform first depth (d1) along the entire length of said portion of the first inlet groove (18);
the reaction groove forming step includes a reaction groove connecting portion forming step of forming at least a portion of the reaction groove (24) which portion is connected with the junction hole (22) by etching the one surface of the base plate (4) to a uniform second depth (d2) along the entire length of said portion of the reaction groove, and
the second inlet groove forming step includes a second inlet groove connecting portion forming step of forming at least a portion of the second inlet groove (20) which portion is connected with the junction hole (22) by etching the other surface of the base plate (4) to a uniform third depth (d3) along the entire length of said portion of the second inlet groove (18); **characterized in that**
the second depth (d2) is larger than the first depth (d1).

3. A method for manufacturing a reactor according to claim 2, wherein:
the third depth (d3) is larger than a difference between the thickness of the base plate (4) and the second depth (d2) and smaller than a difference between the thickness of the base plate (4) and the first depth (d1);
the junction hole forming step includes a first step to be performed simultaneously with the reaction groove connecting portion forming step and adapted to etch a formation area of the junction hole (22) on the one surface of the base plate (4) to the second depth (d2), and a second step to be performed simultaneously with the second inlet groove connecting portion forming step and adapted to etch a formation area of the junction hole (22) on the other surface of the base plate (4) to the third depth (d3); and
a portion etched to the second depth (d2) in the first step and a portion etched to the third depth (d3) in the second step are connected so that the junction hole (22) penetrates the base plate.

## Patentansprüche

1. Reaktor zum Reagierenlassen erster und zweiter Reaktionsmittel, während das Strömen der Reaktionsmittel zugelassen wird, der Folgendes aufweist:
einen kanalbildenden Körper (1a, 1b), in dem ein Kanal (2) ausgebildet ist, der einen ersten Einlasspfad (10), in den das erste Reaktionsmittel eingeführt wird, einen zweiten Einlasspfad (12), in den das zweite Reaktionsmittel eingeführt wird, einen Verbindungskanal (14), der mit einer stromabwärtigen Seite des ersten Einlasspfads (10) und einer stromabwärtigen Seite des zweiten Einlasspfads (12) verbunden ist, um das über den ersten Einlasspfad (10) fließende erste Reaktionsmittel und das über den zweiten Einlasspfad (12) fließende zweite Reaktionsmittel zusammenbringen zu lassen, und einen Reaktionskanal (16) beinhaltet, der mit einer stromabwärtigen Seite des Verbindungskanals (14) verbunden ist, um die beiden in dem Verbindungskanal (14) zusammengebrachten Reaktionsmittel miteinander reagieren zu lassen, während das Strömen der Reaktionsmittel zugelassen wird, wobei:
der kanalbildende Körper (1a, 1b) eine Grundplatte (4), ein erstes Verschlussbauteil (6), das an eine Fläche der Grundplatte (4) gefügt ist, während es die eine Fläche bedeckt, und ein zweites Verschlussbauteil (8) aufweist, das an die andere Fläche der Grundplatte (4) gefügt ist, während es die andere Fläche bedeckt;
eine erste Einlassnut (18) zum Ausbilden des ersten Einlasspfads (10) und eine Reaktionsnut (24) zum Ausbilden des Reaktionskanals (16) in der einen Fläche der Grundplatte (4) ausgebildet sind, während eine zweite Einlassnut (20) zum Ausbilden des zweiten Einlasspfads (12) in der anderen Fläche der Grundplatte (4) ausgebildet ist;
die Grundplatte (4) mit einem Verbindungsloch (22) zum Ausbilden des Verbindungskanals (14) ausgebildet ist, wobei das Verbindungsloch (22) die Grundplatte von der einen Fläche zu der anderen Fläche zwischen der ersten und zweiten Einlassnut (18, 20) und der Reaktionsnut (24) durchdringt, um stromabwärtige Enden der Einlassnuten (18, 20) und ein stromaufwärtiges Ende der Reaktionsnut (24) miteinander zu verbinden;
die Reaktionsnut (24) einen Reaktionsnutverbindungsabschnitt (24a) aufweist, welcher mit dem Verbindungsloch (22) verbunden ist und eine einheitliche Tiefe (d2) auf seiner gesamten Länge hat;
die erste Einlassnut (18) einen Erste-Einlassnut-Verbindungsabschnitt (18a) aufweist, welcher mit dem Verbindungsloch (22) verbunden ist und eine einheitliche Tiefe (d1) auf seiner gesamten Länge hat, und
die zweite Einlassnut (20) einen Zweite-Einlassnut-Verbindungsabschnitt (20a) aufweist, welcher mit dem Verbindungsloch (22) verbunden ist und eine einheitliche Tiefe (d3) auf seiner gesamten Länge hat, **dadurch gekennzeichnet, dass**
die Tiefe (d2) des Reaktionsnutverbindungsabschnitts (24a) größer ist als die Tiefe (d1) des Erste-Einlassnut-Verbindungsabschnitts (18a).

2. Verfahren zur Herstellung eines Reaktors, der einen kanalbildenden Körper (1a, 1b) aufweist, in dem ein Kanal (2) ausgebildet ist, um das Strömen von einem ersten Reaktionsmittel und einem zweiten Reaktionsmittel zuzulassen, mit:
einem Kanalbildender-Körper-Ausbildungsschritt, bei dem der kanalbildende Körper (1a, 1b) derart ausgebildet wird, dass der Kanal (2) einen ersten Einlasspfad (10), in den das erste Reaktionsmittel eingeführt wird, einen zweiten Einlasspfad (12), in den das zweite Reaktionsmittel eingeführt wird, einen Verbindungskanal (14), der mit einer stromabwärtigen Seite des ersten Einlasspfads (10) und einer stromabwärtigen Seite des zweiten Einlasspfads (12) verbunden ist, um das über den ersten Einlasspfad (10) fließende erste Reaktionsmittel und das über den zweiten Einlasspfad (12) fließende zweite Reaktionsmittel zusammenbringen zu lassen, und einen Reaktionskanal (16) beinhaltet, der mit einer stromabwärtigen Seite des Verbindungskanals (14) verbunden ist, um die beiden in dem Verbindungskanal (14) zusammengebrachten Reaktionsmittel miteinander reagieren zu lassen, während das Strömen der Reaktionsmittel zugelassen wird,
wobei der Kanalbildender-Körper-Ausbildungsschritt Folgendes umfasst:
einen Erste-Einlassnut-Ausbildungsschritt, bei dem eine erste Einlassnut (18) zum Ausbilden des ersten Einlasspfads (10) in einer Fläche der Grundplatte (4) durch Ätzen ausgebildet wird;
einen Reaktionsnutausbildungsschritt, bei dem eine Reaktionsnut (24) zum Ausbilden des Reaktionskanals (16) in der einen Fläche der Grundplatte (4) durch Ätzen ausgebildet wird;
einen Zweite-Einlassnut-Ausbildungsschritt, bei dem eine zweite Einlassnut (20) zum Ausbilden des zweiten Einlasspfads (12) in der anderen Fläche der Grundplatte (4) durch Ätzen ausgebildet wird;
einen Verbindungslochausbildungsschritt, bei dem ein Verbindungsloch (22) zum Ausbilden des Verbindungskanals (14) durch Ätzen derart ausgebildet wird, dass das Verbindungsloch (22) die Grundplatte (4) durchdringt, sodass stromabwärtige Enden der ersten und zweiten Einlassnuten (18, 20) miteinander verbunden werden und die stromabwärtigen Enden und ein stromaufwärtiges Ende der Reaktionsnut (24) verbunden werden;
einen ersten Verschlussschritt, bei dem ein erstes Verschlussbauteil (6) an die eine Fläche der Grundplatte (4) gefügt wird, um die eine Fläche zu bedecken, wodurch die Öffnungen der ersten Einlassnut (18), der Reaktionsnut (24) und des Verbindungslochs (22) in der einen Fläche verschlossen werden; und
einen zweiten Verschlussschritt, bei dem ein zweites Verschlussbauteil (8) an die andere Fläche der Grundplatte (4) gefügt wird, um die andere Fläche zu bedecken, wodurch die Öffnungen der zweiten Einlassnut (18) und des Verbindungslochs (22) in der anderen Fläche verschlossen werden, wobei:
der Erste-Einlassnut-Ausbildungsschritt einen Erste-Einlassnut-Verbindungsabschnittausbildungsschritt beinhaltet, bei dem mindestens ein Abschnitt der ersten Einlassnut (18), wobei der Abschnitt mit dem Verbindungsloch (22) verbunden ist, durch Ätzen der einen Fläche der Grundplatte (4) auf eine einheitliche erste Tiefe (d1) über die gesamte Länge des Abschnitts der ersten Einlassnut (18) ausgebildet wird;
der Reaktionsnutausbildungsschritt einen Reaktionsnutverbindungsabschnittausbildungsschritt beinhaltet, bei dem mindestens ein Abschnitt der Reaktionsnut (24), wobei der Abschnitt mit dem Verbindungsloch (22) verbunden ist, durch Ätzen der einen Fläche der Grundplatte (4) auf eine einheitliche zweite Tiefe (d2) über die gesamte Länge des Abschnitts der Reaktionsnut (24) ausgebildet wird, und
der Zweite-Einlassnut-Ausbildungsschritt einen Zweite-Einlassnut-Verbindungsabschnittausbildungsschritt beinhaltet, bei dem mindestens ein Abschnitt der zweiten Einlassnut (20), wobei der Abschnitt mit dem Verbindungsloch (22) verbunden ist, durch Ätzen der anderen Fläche der Grundplatte (4) auf eine einheitliche dritte Tiefe (d3) über die gesamte Länge des Abschnitts der zweiten Einlassnut (20) ausgebildet wird;
**dadurch gekennzeichnet, dass**
die zweite Tiefe (d2) größer ist als die erste Tiefe (d1)

3. Verfahren zur Herstellung eines Reaktors nach Anspruch 2, wobei:
die dritte Tiefe (d3) größer ist als eine Differenz zwischen der Stärke der Grundplatte (4) und der zweiten Tiefe (d2) sowie kleiner als eine Differenz zwischen der Stärke der Grundplatte (4) und der ersten Tiefe (d1);
der Verbindungslochausbildungsschritt einen ersten Schritt, der gleichzeitig mit dem Reaktionsnutverbindungsabschnittausbildungsschritt durchgeführt wird und dazu angepasst ist, einen Ausbildungsbereich des Verbindungslochs (22) an der einen Fläche der Grundplatte (4) auf die zweite Tiefe (d2) zu ätzen, und einen zweiten Schritt beinhaltet, der gleichzeitig mit dem Zweite-Einlassnut-Verbindungsabschnittausbildungsschritt durchgeführt wird und dazu angepasst ist, einen Ausbildungsbereich des Verbindungslochs (22) an der anderen Fläche der Grundplatte (4) auf die dritte Tiefe (d3) zu ätzen; und
ein Abschnitt, der in dem ersten Schritt auf die zweite Tiefe (d2) geätzt wurde, und ein Abschnitt, der in dem zweiten Schritt auf die dritte Tiefe (d3) geätzt wurde, derart verbunden werden, dass das Verbindungsloch (22) die Grundplatte (4) durchdringt.

## Revendications

1. Réacteur destiné à faire réagir un premier et un second réactifs tout en permettant l'écoulement des réactifs, comprenant :
un corps de formation de canal (1a, 1b) formé en interne avec un canal (2) comprenant un premier trajet d'admission (10) ayant le premier réactif introduit à l'intérieur , un second trajet d'admission (12) ayant le second réactif introduit à l'intérieur , un canal de jonction (14) relié à un côté aval du premier trajet d'admission (10) et un côté aval du second trajet d'admission (12) destiné à permettre au premier réactif de qui s'écoule via le premier trajet d'admission (10) et au second réactif qui s'écoule via le second trajet d'admission (12) de se rejoindre, et un canal de réaction (16) relié à un côté aval du canal de jonction (14) afin de faire réagir les deux réactifs joints dans le canal de jonction (14) l'un avec l'autre tout en permettant l'écoulement des réactifs, dans lequel :
le corps de formation de canal (1a, 1b) comprend une plaque de base (4), un premier élément d'étanchéité (6) lié à une surface de la plaque de base (4) tout en recouvrant la surface, et un second élément d'étanchéité (8) lié à l'autre surface de la plaque de base (4) tout en recouvrant l'autre surface ;
une première rainure d'admission (18) destinée à former le premier trajet d'admission (10) et une rainure de réaction (24) destinée à former le canal de réaction (16) sont formées dans la surface de la plaque de base (4) tandis qu'une seconde rainure d'admission (20) destinée à former le second trajet d'admission (12) est formée dans l'autre surface de la plaque de base (4) ;
la plaque de base (4) est formée avec un orifice de jonction (22) destiné à former le canal de jonction (14), l'orifice de jonction (22) pénétrant dans la plaque de base depuis la surface vers l'autre surface entre la première et la seconde rainures d'admission (18, 20) et la rainure de réaction (24) de façon à interconnecter les extrémités aval des rainures d'admission (18, 20) et une extrémité amont de la rainure de réaction (24) ;
la rainure de réaction (24) possède une partie de raccordement de rainure de réaction (24a) qui est reliée à l'orifice de jonction (22) et qui présente une profondeur uniforme (d2) sur toute sa longueur,
la première rainure d'admission (18) possède une partie de raccordement de première rainure d'admission (18a) qui est reliée à l'orifice de jonction (22) et qui présente une profondeur uniforme (d1) sur toute sa longueur, et
la seconde rainure d'admission (20) possède une seconde partie de raccordement de rainure d'admission (20a) qui est reliée à l'orifice de jonction (22) et qui présente une profondeur uniforme (d3) sur toute sa longueur, **caractérisé en ce que**
la profondeur (d2) de la partie de raccordement de rainure de réaction (24a) est supérieure à la profondeur (d1) de la partie de raccordement de première rainure d'admission (18a).

2. Procédé de fabrication d'un réacteur comprenant un corps de formation de canal (1a, 1b) formé en interne avec un canal (2) destiné à permettre l'écoulement d'un premier réactif et d'un second réactif, comprenant :
une étape de formation de corps de formation de canal qui consiste à former le corps de formation de canal (1a, 1b) de sorte que le canal (2) comprenne un premier trajet d'admission (10) ayant le premier réactif introduit l'intérieur , un second trajet d'admission (12) ayant le second réactif introduit à l'intérieur, un canal de jonction (14) relié à un côté aval du premier trajet d'admission (10) et un côté aval du second trajet d'admission (12) afin de permettre au premier réactif qui s'écoule via le premier trajet d'admission (10) et au second réactif qui s'écoule via le second trajet d'admission (12) de se joindre, et un canal de réaction (16) relié à un côté aval du canal de jonction (14) pour faire réagir les deux réactifs joints dans le canal de jonction (14) l'un avec l'autre tout en permettant l'écoulement des réactifs,
dans lequel l'étape de formation de corps de formation de canal comprend :
une étape de formation d'une première rainure d'admission qui consiste à former une première rainure d'admission (18) destinée à former le premier trajet d'admission (10) dans une surface d'une plaque de base (4) par attaque chimique ;
une étape de formation de rainure de réaction qui consiste à former une rainure de réaction (24) destinée à former le canal de réaction (16) dans la surface de la plaque de base (4) par attaque chimique ;
une étape de formation de seconde rainure d'admission qui consiste à former une seconde rainure d'admission (20) destinée à former le second trajet d'admission (12) dans l'autre surface de la plaque de base (4) par attaque chimique ;
une étape de formation d'orifice de jonction qui consiste à former un orifice de jonction (22) destiné à former le canal de jonction (14) par attaque chimique de sorte que l'orifice de jonction (22) pénètre dans la plaque de base (4) de façon à relier les extrémités aval de la première et de la seconde rainures d'admission (18, 20) l'une à l'autre et à relier les extrémités aval et une extrémité amont de la rainure de réaction (24) ;
une première étape de fermeture qui consiste à lier un premier élément d'étanchéité (6) à ladite une surface de la plaque de base (4) pour recouvrir ladite surface, afin de fermer les ouvertures de la première rainure d'admission (18), la rainure de réaction (24) et l'orifice de jonction (22) dans ladite surface ; et
une seconde étape de fermeture qui consiste à lier un second élément d'étanchéité (8) à l'autre surface de la plaque de base (4) afin de recouvrir l'autre surface, de façon à fermer les ouvertures de la seconde rainure d'admission (20) et l'orifice de jonction (22) dans l'autre surface ;
l'étape de formation de première rainure d'admission comprend une étape de formation de partie de raccordement de première rainure d'admission qui consiste à former au moins une partie de la première rainure d'admission (18), ladite partie étant reliée à l'orifice de jonction (22) par attaque chimique de la surface de la plaque de base (4) selon une première profondeur uniforme (d1) sur toute la longueur de ladite partie de la première rainure d'admission (18) ;
l'étape de formation de rainure de réaction comprend une étape de formation de partie de raccordement de rainure de réaction qui consiste à former au moins une partie de la rainure de réaction (24), ladite partie étant reliée à l'orifice de jonction (22) par attaque chimique de la surface de la plaque de base (4) selon une seconde profondeur uniforme (d2) sur toute la longueur de ladite partie de la rainure de réaction, et
l'étape de formation de seconde rainure d'admission comprend une étape de formation de partie de raccordement de seconde rainure d'admission qui consiste à former au moins une partie de la seconde rainure d'admission (20), ladite partie étant reliée à l'orifice de jonction (22) par attaque chimique de l'autre surface de la plaque de base (4) selon une troisième profondeur uniforme (d3) sur toute la longueur de ladite seconde rainure d'admission (18) ; **caractérisé en ce que**
la seconde profondeur (d2) est supérieure à la première profondeur (d1).

3. Procédé de fabrication d'un réacteur selon la revendication 2, dans lequel :
la troisième profondeur (d3) est supérieure à une différence entre l'épaisseur de la plaque de base (4) et la seconde profondeur (d2) et inférieure à une différence entre l'épaisseur de la plaque de base (4) et la première profondeur (d1) ;
l'étape de formation de l'orifice de jonction comprend une première étape à exécuter en même temps que l'étape de formation de partie de raccordement de rainure de réaction et adaptée pour attaquer chimiquement une zone de formation de l'orifice de jonction (22) sur la surface de la plaque de base (4) selon la seconde profondeur (d2), et une seconde étape à exécuter en même temps que l'étape de formation de seconde partie de raccordement de rainure d'admission et adaptée pour attaquer chimiquement une zone de formation de l'orifice de jonction (22) sur l'autre surface de la plaque de base (4) selon la troisième profondeur (d3) ;
et
une partie attaquée chimiquement selon la seconde profondeur (d2) à la première étape et une partie attaquée chimiquement selon la troisième profondeur (d3) à la seconde étape sont reliées de sorte que l'orifice de jonction (22) pénètre dans la plaque de base.
